# EUROPÄISCHE PATENTSCHRIFT

(11) **EP 2 877 867 B1**
(45) Veröffentlichungstag und Bekanntmachung des Hinweises auf die Patenterteilung: **12.10.2016**
(21) Anmeldenummer: 13726747.2
(22) Anmeldetag: 29.05.2013
(51) Int. Cl.: G01R 31/28, G01R 1/073, G01R 1/067

(54) **VORRICHTUNG ZUM TESTEN VON WAFERN**
APPARATUS FOR TESTING WAFERS
DISPOSITIF DE TEST DE TRANCHES DE SEMI-CONDUCTEURS

(30) Priorität: 26.07.2012 DE 102012014812
(43) Veröffentlichungstag der Anmeldung: 03.06.2015
(73) Patentinhaber: ETEL S.A., 2112 Môtiers (CH)
(72) Erfinder: VAUCHER, Jean-Marc, CH-2108 Couvet (CH)
(74) Vertreter: Pleyer, Hans Anno
(86) Internationale Anmeldenummer: PCT/EP2013/061077
(87) Internationale Veröffentlichungsnummer: WO 2014/016018

(56) Entgegenhaltungen:
- EP-A1- 0 615 131
- WO-A1-2007/024031
- DE-A1- 10 039 336
- US-A1- 2010 148 814

## Beschreibung

Die vorliegende Erfindung betrifft eine Vorrichtung zum Testen von Wafern, auch als Tester bezeichnet. Mit solchen Testern werden Integrierte Schaltungen auf einem Wafer getestet, noch bevor diese vereinzelt und in separate Gehäuse verpackt werden.

Ein typischer Aufbau eines Testers ist in der US 6906546 B2 beschrieben und schematisch in der Figur 1 dargestellt. Ein Wafer 6 liegt auf einem Substratträger 5. Am Rahmen 1 des Testers ist ein auswechselbarer, an die zu testende Integrierte Schaltung angepasster Tastkopf 7 befestigt, der mit seinen federnden Prüfkontakten 8 die elektrischen Kontakte des Wafers (also die sogenannten Bondpads der Integrierten Schaltungen, an denen später Kontaktdrähte befestigt werden) kontaktiert und mit einer Elektronik zum Testen der Integrierten Schaltungen verbindet. Der Substratträger 5 ist auf einem Z-Theta-Tisch 4 angeordnet, mit dem der Substratträger 5 in Z-Richtung auf die Prüfkontakte 8 zubewegt und um diese Z-Richtung gedreht werden kann. Der Z-Theta-Tisch 4 ist auf zwei gekreuzten Linearachsen 2, 3 angeordnet, mit denen der Substratträger 5 in X- und Y-Richtung bewegt werden kann.

Mittels der beiden Linearachsen 2, 3 und der Rotationsachse des Z-Theta-Tisches 4 wird der Wafer 6 zum Tastkopf 7 ausgerichtet. Mit dem Z-Theta-Tisch wird der Wafer dann auf die Prüfkontakte 8 gepresst und ein Testprogram gestartet.

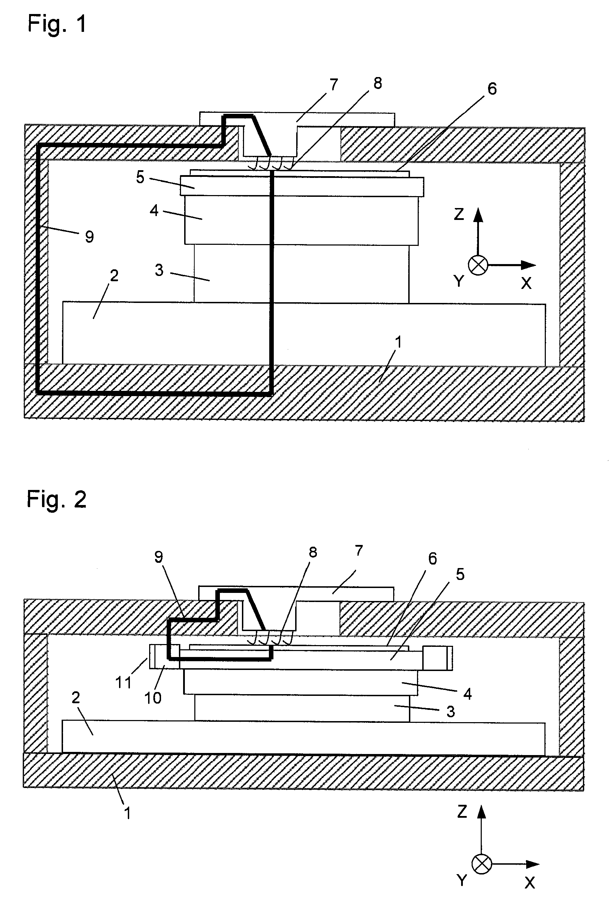

Die Federkraft eines einzelnen Prüfkontaktes 8 ist dabei gering. Da aber sehr viele solcher Prüfkontakte gleichzeitig zum Einsatz kommen, kann die Kraft, mit der ein Wafer 6 gegen den Tastkopf 7 gedrückt werden muss, im Bereich mehrerer 1000 N liegen. Diese hohe Kraft zwischen Tastkopf 1 und Wafer 6 muss in einem Tester gemäß Figur 1 vom Tastkopf 7 über den Rahmen 1, die Linearachsen 2, 3 und den Z-Theta-Tisch 4 auf den Substratträger 5 übertragen werden, wie dies mit der Kraftschleife 9 angedeutet ist. Alle diese Elemente müssen daher so ausgelegt werden, dass sie solchen Kräften widerstehen können. Entsprechend groß und schwer müssen die einzelnen Komponenten gebaut werden.

Um eine Beweglichkeit in X- und Y-Richtung zu erzielen, sind auch andere Vorrichtungen als die in der Figur 1 beschriebenen möglich. So eigenen sich Gantry-Anordnungen ebenso wie gekreuzte Linearachsen wie in der US 5760564 A beschrieben oder Planarmotoren wie in der US 6531793 B1 gezeigt. Wichtig ist, dass der Substratträger in zwei linear unabhängigen Richtungen, die parallel zu einer Ebene des Substratträgers liegen, relativ zum Abtastkopf beweglich ist.

In der US 7656174 B2 wurde bereits vorgeschlagen, die Kraft zwischen dem Tastkopf und dem Wafer mit einem Vakuum oder mit einem magnetischen Element (Elektromagnet) zu erzeugen. Auf diese Weise wirkt die Kraft zum Anpressen der Prüfkontakte auf die elektrischen Kontakte unmittelbar zwischen dem Substratträger und dem Tastkopf, der Rahmen des Testers und die sonstigen Bestandteile werden nicht mit diesen großen Kräften belastet und können leichter und kleiner ausgeführt werden.

Die EP0615131 A1, DE10039336 A1, US2010/148814 A1 sowie WO2007/024031 offenbaren auch eine Vorrichtung zum Testen von Integrierten Schaltungen.

Für kommende Generationen von Integrierten Schaltkreisen, die nach dem Moore'schen Gesetz immer höher integriert und mit feineren Strukturen hergestellt werden, werden Tests immer aufwändiger. Die sichere Kontaktierung von immer zahlreicheren und kleineren elektrischen Kontakten mit immer feineren Prüfkontakten erfordert eine zunehmend genauere Prozesskontrolle nicht nur bei der Fertigung der Integrierten Schaltungen, sondern auch beim Testen.

Aufgabe der Erfindung ist es daher, eine Vorrichtung zum Testen von Integrierten Schaltungen anzugeben, die eine besonders gute Prozesskontrolle beim Testen von Integrierten Schaltungen ermöglicht. Diese Aufgabe wird gelöst durch eine Vorrichtung mit den Merkmalen des Anspruchs 1. Vorteilhafte Details der Vorrichtung ergeben sich aus den von Anspruch 1 anhängigen Ansprüchen.

Es wird eine Vorrichtung zum Testen von Integrierten Schaltungen mittels eines Tastkopfes mit Prüfkontakten beschrieben. Die Prüfkontakte werden auf elektrische Kontakte eines Substrats gepresst, etwa eines Wafers mit Integrierten Schaltungen. Die Vorrichtung weist einen Rahmen auf, an dem der Tastkopf befestigt ist, sowie einen Substratträger zum Aufnehmen des Substrats. Ein magnetisches Element erzeugt die Kraft, mit der die Prüfkontakte auf die elektrischen Kontakte der Integrierten Schaltung gedrückt werden. Hierbei kommen wenigstens drei Magnetaktuatoren zum Einsatz, denen jeweils ein Abstandssensor zugeordnet ist, und die um den Substratträger angeordnet sind, so dass mittels eines Reglers die Abstände zwischen den Magnetaktuatoren und dem Rahmen und damit zwischen dem Substratträger und dem Tastkopf einstellbar sind.

Die Kraft, die von den wenigstens drei Magnetaktuatoren ausgeübt wird, wirkt unmittelbar zwischen dem Tastkopf (bzw. dem Rahmen, an dem der Tastkopf befestigt ist) und dem Substratträger. Der Magnetkreis überbrückt dabei den mechanischen Spalt, in dem auch die federnden Prüfkontakte liegen. Die Federkonstante dieser Prüfkontakte und der Abstand zwischen Abtastkopf und Substrat bestimmen die Anpresskraft, die die sonstige Mechanik des Testers nicht belastet.

Durch die Verwendung von drei oder mehr Magnetaktuatoren ist eine sehr gleichmäßige Einstellung des Abstandes zwischen Abtastkopf und Substratträger möglich. Verschiedenste Einflüsse, die zu einem ungleichmäßigen Abstandsverlauf innerhalb des Substrats oder innerhalb der zu prüfenden Integrierten Schaltung führen würden, können regelungstechnisch ausgeglichen werden. So ist die Belastung des Substratträgers sehr unterschiedlich, je nachdem ob das jeweilige Substrat gerade in seiner Mitte oder eher am Rand getestet wird. Greift die Anpresskraft nicht mittig an, so wird der Substratträger zu einer Verkippung neigen, der mittels geeigneter Ansteuerung der drei oder mehr Magnetaktuatoren entgegengesteuert werden kann.

Außerdem kann die Mechanik des Z-Theta-Tisches und der Linearachsen erheblich entlastet und der Tester damit deutlich leichter aufgebaut werden.

Diese Z-Achse muss nun nämlich nicht mehr die Anpresskraft aufbringen, sondern nur noch den Substratträger mit dem Substrat in die Nähe des Tastkopfes bringen und dabei allenfalls die Schwerkraft der bewegten Teile überwinden. Über einen großen Verfahrbereich (einige Zentimeter) des Substratträgers ist hierfür nur eine vergleichsweise kleine Kraft notwendig. Im letzten, für das eigentliche Testen wichtigen Teil des Verfahrbereiches (einige zehntel Millimeter), in dem der Kontakt zwischen den Bondpads und den Prüfkontakten hergestellt wird, übernehmen dann die Magnetaktuatoren die Krafterzeugung und entlasten so die darunter liegende Mechanik zum Positionieren des Substratträgers.

Die bewegten Massen werden dadurch insgesamt kleiner, die Positionierung schneller und genauer, und die am Aufstellort des Testers in den Boden ein gekoppelten Vibrationen werden reduziert. Außerdem werden durch die reduzierte Kraft in der vertikalen Z-Richtung mechanische Deformationen vermieden, die Positionierung des Substrats wird dadurch auch in der horizontalen X-Y-Richtung genauer.

Weitere Vorteile sowie Einzelheiten der vorliegenden Erfindung ergeben sich aus der nachfolgenden Beschreibung einer bevorzugten Ausführungsform anhand der Figuren. Dabei zeigt
- Figur 1: eine Vorrichtung zum Testen von Integrierten Schaltungen nach dem Stand der Technik,
- Figur 2: eine erfindungsgemäße Vorrichtung zum Testen von Integrierten Schaltungen in einer Seitenansicht,
- Figur 3: die Vorrichtung der Figur 2 in einer Draufsicht,
- Figur 4: eine Einrichtung zum Regeln von Magnetaktuatoren der Vorrichtung zum Testen von Integrierten Schaltungen.

Die Figur 1 zeigt eine Vorrichtung zum Testen von Integrierten Schaltungen nach dem Stand der Technik und wurde einleitend bereits beschrieben.

Die Figur 2 zeigt eine erfindungsgemäße Vorrichtung zum Testen von Integrierten Schaltungen, bei der die bereits in der Figur 1 erklärten Bestandteile mit identischen Bezugszeichen versehen sind. In diesem Ausführungsbeispiel neu hinzugekommen sind Magnetaktuatoren 10, die in Abständen um den Substratträger 5 herum angeordnet sind. Um den Abstand zwischen dem Substratträger 5 und dem Rahmen 1 bzw. dem am Rahmen befestigten Tastkopf 7 einstellen zu können, ist jedem Magnetaktuator 10 außerdem ein Abstandssensor 11 zugeordnet. Die Abstandssensoren 11 sind vorzugsweise als induktive Abstandssensoren ausgeführt. Es kommen aber auch andere Sensoren in Frage, die beispielsweise auf kapazitiven oder optischen Effekten beruhen.

Jeder Magnetaktuator 10 besteht aus einem E - förmigen Eisenkern, der mit einer oder mehreren Spulen bewickelt ist. Ein durch die Spulen fließender Strom bewirkt einen magnetischen Fluss durch den Eisenkern. Die freien Schenkel des Eisenkerns sind dabei so auf ferromagnetische Bereiche des Rahmens 1 ausgerichtet, dass der magnetische Kreis über diese ferromagnetischen Bereiche geschlossen wird. Es resultiert eine magnetische Anziehungskraft zwischen den Magnetaktuatoren 10 und den ferromagnetischen Bereichen des Rahmens 1, die bestrebt ist, den Luftspalt zwischen den Magnetaktuatoren 10 und dem Rahmen 1 zu verringern. Diese auch als Reluktanzkraft bezeichnete Kraft ist der Federkraft der Prüfkontakte 8 entgegen gerichtet und erzeugt die Anpresskraft, mit der die Prüfkontakte 8 des Tastkopfes 7 auf die elektrischen Kontakte des zu testenden Substrats 6 gedrückt werden.

Für die Größe der Kraft gilt näherungsweise F = K * i²/ d², wobei i der Strom durch die Spule, d die Größe des Luftspalts und K eine Konstante mit der Einheit Nm²/A² ist. Die Kraft ist also proportional zum Quadrat des Stromes und umgekehrt proportional zum Quadrat der Größe des Luftspaltes. Der nutzbare Bereich des Magnetaktuators beträgt etwa 1 mm, da die Magnetkräfte außerhalb dieses Bereichs zu klein werden.

In einer bevorzugten Ausführungsform ist der mittlere der drei freien Schenkel des E-förmigen Eisenkerns mit einer Spule umwickelt, die den Zwischenraum zu den beiden äußeren Schenkeln ausfüllt. Der mittlere, von der Spule umwickelte Schenkel sollte dann etwa doppelt so breit sein wie die beiden äußeren Schenkel, um eine ähnliche magnetische Flussdichte in jedem Schenkel zu erhalten. Der mittlere Schenkel trägt außerdem einen Permanentmagnet, der in der Ruhelage die Schwerkraft in etwa kompensiert oder sogar einen Teil der Anpresskraft übernimmt. So kann durch einen variablen Spulenstrom eine Gesamtkraft in beide vertikalen Richtungen (aufwärts und abwärts) bewirkt werden. Außerdem reduziert sich durch den Permanentmagnet der maximal nötige Strom, so dass die thermische Belastung sinkt.

In der Figur 2 ist gut zu erkennen, dass die Kraftschleife 9 zum Erzeugen der Anpresskraft nun wesentlich kleiner ist als in der in Figur 1 gezeigten Vorrichtung. Die X-Achse 2, die Y-Achse 3 und der Z-Theta-Tisch 4 werden mit dieser Anpresskraft nicht belastet. Auch der Rahmen 1 muss dieser Kraft nur in einem kleinen Bereich standhalten.

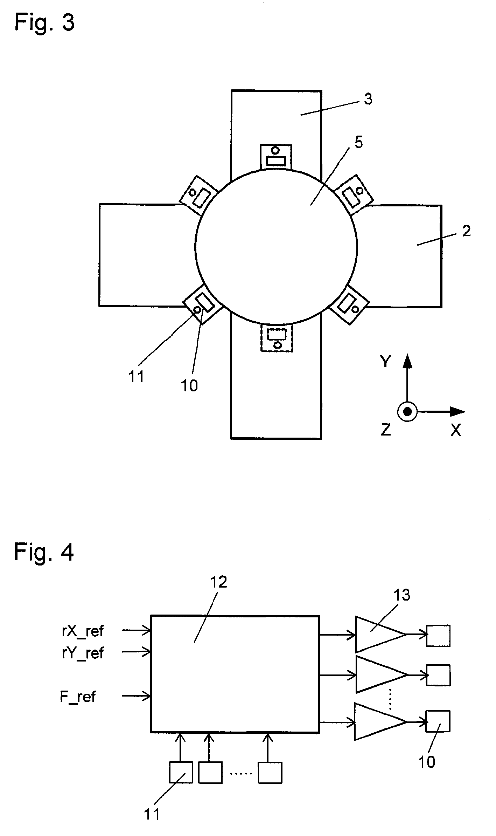

In der Figur 3 ist eine Draufsicht auf einige Bestandteile des Testers der Figur 2 gezeigt. Man erkennt die gekreuzten Linearachsen 2, 3, sowie den darauf angeordneten Substratträger 5. Um den Substratträger 5 herum sind in regelmäßigen Winkelabständen drei Magnetaktuatoren 10 mit jeweils einem zugeordneten Abstandssensor 11 gezeigt. In einem Ausführungsbeispiel sind drei solcher Magnetaktuatoren 10 im Abstand von 120 Grad angeordnet (mit durchgezogenen Linien gezeichnet), in einem weiteren Ausführungsbeispiel sind zusätzlich weitere drei solcher Magnetaktuatoren 10 (mit unterbrochenen Linien gezeichnet) vorgesehen, so dass der Abstand zwischen zwei benachbarten Magnetaktuatoren bei regelmäßiger Anordnung noch 60 Grad beträgt.

Die Verwendung von drei oder mehr solcher Aktuatoren 10 nebst Abstandssensoren 11 hat den Vorteil, dass der Substratträger 5 nicht nur in einer Z-Richtung verstellbar ist, sondern auch (in gewissen Grenzen) um die X- und Y-Richtung gekippt werden kann. Durch die Abstandsmessung an jedem Magnetaktuator 10 kann die Verkippung gezielt eingestellt werden. Somit ist das Substrat 6 in allen sechs Freiheitsgraden positionierbar. Die Richtungen X und Y werden mit Hilfe der Linearachsen 2, 3 eingestellt, die Vorpositionierung in Z-Richtung und die rZ-Drehung (also Drehung um die Z-Achse) mittels des Z-Theta-Tisches 4. Während des Testens eines Wafers wird die Feinpositionierung in Z-Richtung (und damit die Anpresskraft) sowie die rX-und rY-Kippungen (um die X- bzw. Y-Achse) durch eine geeignete Ansteuerung der Magnetaktuatoren 10 eingestellt. Die nötige Beweglichkeit zum Verkippen des Substratträgers 5 kann mittels geeigneter Gelenke (z.B. Blattfedern) sichergestellt werden, falls die vorhandenen Elastizitäten im System nicht ausreichend sind.

Die Verwendung von mehr als drei Magnetaktuatoren 10 kann dann notwendig sein, wenn einzelne Aktuatoren 10 in extremen Positionen des Substratträgers 5 (also beim Testen von Randbereichen des Wafers) nicht mehr den ferromagnetischen Bereichen des Rahmens 1 gegenüberliegen und somit keine Kraft erzeugen können.

Die Figur 4 zeigt einen Regler 12 zum Ansteuern der Magnetaktuatoren 10. Dieser Regler kann als SISO - Regler (Single Input, Single Output) aufgebaut sein, bei dem für jedes Sensor/Aktuator - Paar ein eigener PID - Regler vorhanden ist. So eine Struktur ist allerdings dann nachteilig, wenn mehr Sensor/Aktuator - Paare vorhanden sind als Freiheitsgrade zu regeln sind. In diesem Fall ist ein MIMO - Regler (Multiple Input, Multiple Output) bevorzugt. Hier werden die Signale aller Sensoren 11 zunächst in die Koordinaten Z, rX und rY umgerechnet (Sensortransformation) und diese jeweils einem PID-Regler zugeführt, so dass nun genau ein PID-Regler für jeden Freiheitsgrad vorhanden ist. Die Ausgänge dieser Regler werden dann in Ansteuersignale für die Magnetaktuatoren 10 umgewandelt (Aktuatortransformation). Trotz des erhöhten rechnerischen Aufwandes für die Transformationen sind MIMO - Regler bevorzugt, da sie bessere Ergebnisse liefern.

Die wichtigste Vorgabe für diesen Regler 12 ist der Sollwert für die Anpresskraft F_ref, oder gleichbedeutend (wegen des linearen Zusammenhangs zwischen der Federkraft und dem Federweg der Prüfkontakte 8) der Sollwert für den Abstand zwischen dem Substratträger 5 und dem Tastkopf 7. Die beiden Sollwerte sind äquivalent zu verwenden und unterscheiden sich nur durch eine Konstante. Außerdem kann eine Verkippung rX_ref oder rY_ref vorgegeben werden, um die beiden Freiheitsgrade rX und rY einstellen zu können. In den meisten Anwendungsfällen werden diese Vorgaben Null sein. Ein Anwendungsfall für von Null verschiedene Vorgaben könnte die Berücksichtigung eines keilförmigen Substrates 6 sein, so dass trotz der Keilform des Substrates 6 alle Prüfkontakte die gleiche Kompression und damit die gleiche Anpresskraft erfahren.

Dem Regler 12 werden außerdem die Abstandsmessungen der Abstandssensoren 11 zugeführt. Aus den Vorgabewerten rX_ref, rY_ref, F_ref berechnet der Regler 12 sodann Sollwerte für die Ströme in den Magnetaktuatoren 10. Diese Sollwerte werden an Verstärker 13 abgegeben, die diese Ströme in den Magnetaktuatoren 10 einstellen.

Anstelle der Vorgabe eines Abstands oder einer Kraft könnten die Magnetaktuatoren 10 auch so geregelt werden, dass die Z-Achse des Z-Theta-Tisches 4 keine oder nur noch eine geringe Last tragen muss. Hierzu wird dem Regler (12) ein maximaler Strom für die Z-Achse des Z-Theta-Tisches (4) vorgegeben, so dass dessen Z-Achse entlastet wird und die eigentliche Anpresskraft (zumindest größtenteils) von den Magnetaktuatoren 10 aufgebracht wird. Die Vorgabe eines Abstandes zwischen Wafer 6 und Tastkopf 7 kann dann wie im Stand der Technik über den Regelkreis des Z-Theta-Tisches 4 erfolgen.

Auf einem Wafer 6 befinden sich üblicherweise zahlreiche identische Integrierte Schaltungen, die nacheinander getestet werden müssen. Der Wafer muss daher in X- und Y-Richtung immer wieder neu positioniert und so schrittweise getestet werden. Werden hierbei Bereiche am Rand des Wafers getestet, droht durch die hohe Anpresskraft eine Verkippung des Substratträgers 5. Diese wird zwar durch die Regelung 12 wegen der Vorgabe rX_ref = rY_ref = 0 ausgeregelt, hierfür ist jedoch eine gewisse Regelzeit nötig. Um diese Zeit zu verkürzen und damit den Vorgang des Testens insgesamt zu beschleunigen, kann die auftretende Verkippung vorgesteuert werden. Denn kennt der Regler 12 die aktuell zu testende Position, so kann er die zum Ausgleich der kippenden Kräfte notwendigen Ströme in den Magnetaktuatoren 10 berechnen und als Vorsteuerwerte in den Stromregelkreisen berücksichtigen. Der Regler 12 weist also eine Vorsteuerung auf, die bei der Ansteuerung der Magnetaktuatoren 10 eine von der X-Y-Position des Substratträgers 5 relativ zum Tastkopf 7 abhängige Verteilung der Kräfte auf die einzelnen Magnetaktuatoren 10 berücksichtigt. So muss der Regler 12 nur echte Störungen und Ungenauigkeiten ausregeln und nicht eigentlich bekannte Effekte.

## Patentansprüche

1. Vorrichtung zum Testen von Integrierten Schaltungen mittels eines Tastkopfes (7) mit Prüfkontakten (8), die auf elektrische Kontakte eines Substrats (6) gepresst werden, mit einem Rahmen (1), an dem der Tastkopf (7) befestigt ist, mit einem Substratträger (5) zum Aufnehmen des Substrats (6), und mit einem magnetischen Element zum Erzeugen einer Kraft, mit der die Prüfkontakte (8) auf die elektrischen Kontakte der Integrierten Schaltung gepresst werden, **gekennzeichnet durch** wenigstens drei Magnetaktuatoren (10), denen jeweils ein Abstandssensor (11) zugeordnet ist, und die um den Substratträger (5) angeordnet sind, so dass die Abstände zwischen den Magnetaktuatoren (10) und dem Rahmen (1) und damit zwischen dem Substratträger (5) und dem Tastkopf (7) einstellbar sind.

2. Vorrichtung nach Anspruch 1, **dadurch gekennzeichnet, dass** der Substratträger (5) in zwei linear unabhängigen Richtungen (X, Y), die parallel zu einer Ebene des Substratträgers (5) liegen, relativ zum Abtastkopf (7) beweglich ist.

3. Vorrichtung nach Anspruch 2, **dadurch gekennzeichnet, dass** der Substratträger (5) relativ zum Rahmen (1) mittels einer ersten angetriebenen Linearachse (2) in der ersten Richtung (X) verfahrbar ist, und dass auf und senkrecht zu dieser ersten Linearachse (2) eine zweite Linearachse (3) angeordnet ist, mit der der Substratträger (5) in der zweiten Richtung (Y) verfahrbar angeordnet ist.

4. Vorrichtung nach Anspruch 2 oder 3, **dadurch gekennzeichnet, dass** der Substratträger (5) auf einem Z-Theta-Tisch (4) angeordnet ist, mit dem das Substrat in einer dritten Richtung (Z), die senkrecht auf die erste und zweite Richtung (X, Y) steht, sowie rotatorisch um die dritte Richtung (Z) beweglich ist.

5. Vorrichtung nach einem der vorhergehenden Ansprüche, **dadurch gekennzeichnet, dass** einem Regler (12) zur Ansteuerung der Magnetaktuatoren (10) eine definierte Anpresskraft (F_ref) oder ein definierter Abstand zwischen dem Substratträgers (5) und dem Tastkopf (7) vorgebbar ist.

6. Vorrichtung nach Anspruch 4 oder 5, **dadurch gekennzeichnet, dass** dem Regler (12) ein maximaler Strom für die Z-Achse des Z-Theta-Tisches (4) vorgebbar ist.

7. Vorrichtung nach Anspruch 5 oder 6, **dadurch gekennzeichnet, dass** mittels des Reglers (12) eine Verkippung des Substratträgers (5) um die erste oder zweite Richtung (X, Y) einstellbar ist.

8. Vorrichtung nach Anspruch 5, 6 oder 7, **dadurch gekennzeichnet, dass** der Regler (12) eine Vorsteuerung aufweist, die bei der Ansteuerung der Magnetaktuatoren (10) eine von der Position des Substratträgers (5) relativ zum Tastkopf (7) abhängige Verteilung der Kräfte auf die einzelnen Magnetaktuatoren (10) berücksichtigt.

9. Vorrichtung nach einem der vorhergehenden Ansprüche, **dadurch gekennzeichnet, dass** die Magnetaktuatoren (10) einen Magnetkreis bilden, der über den Luftspalt zwischen dem Substratträger (5) und ferromagnetischen Bereichen des Rahmens (1) geschlossen ist, so dass eine Reluktanzkraft entsteht, die der Federkraft der Prüfkontakte (8) entgegenwirkt.

10. Vorrichtung nach Anspruch 9, **dadurch gekennzeichnet, dass** die Magnetaktuatoren (10) aus E-förmigen Eisenkernen aufgebaut sind, deren Schenkel auf die ferromagnetischen Bereiche des Rahmens (1) gerichtet und die mit wenigstens einer Spule bewickelt sind.

## Claims

1. Apparatus for testing integrated circuits by means of a sensing head (7) having test contacts (8) which are pressed onto electrical contacts of a substrate (6), having a frame (1) to which the sensing head (7) is fastened, having a substrate carrier (5) for accommodating the substrate (6), and having a magnetic element for generating a force which is used to press the test contacts (8) onto the electrical contacts of the integrated circuit, **characterized by** at least three magnetic actuators (10), each of which is assigned a distance sensor (11) and which are arranged around the substrate carrier (5), such that the distances between the magnetic actuators (10) and the frame (1) and therefore between the substrate carrier (5) and the sensing head (7) are adjustable.

2. Apparatus according to Claim 1, **characterized in that** the substrate carrier (5) is movable relative to the sensing head (7) in two linearly independent directions (X, Y) which are parallel to a plane of the substrate carrier (5).

3. Apparatus according to Claim 2, **characterized in that** the substrate carrier (5) is movable relative to the frame (1) in the first direction (X) by means of a first driven linear axle (2), and **in that** a second linear axle (3) is arranged on and perpendicular to this first linear axle (2) and is used to arrange the substrate carrier (5) such that it is movable in the second direction (Y).

4. Apparatus according to Claim 2 or 3, **characterized in that** the substrate carrier (5) is arranged on a Z-theta table (4) which can be used to move the substrate in a third direction (Z), which is perpendicular to the first and second directions (X, Y), and rotationally about the third direction (Z).

5. Apparatus according to one of the preceding claims, **characterized in that** a defined pressing force (F_ref) or a defined distance between the substrate carrier (5) and the sensing head (7) can be predefined to a controller (12) for actuating the magnetic actuators (10).

6. Apparatus according to Claim 4 or 5, **characterized in that** a maximum current for the Z axis of the Z-theta table (4) can be predefined to the controller (12).

7. Apparatus according to Claim 5 or 6, **characterized in that** the controller (12) can be used to adjust tilting of the substrate carrier (5) around the first or second direction (X, Y).

8. Apparatus according to Claim 5, 6 or 7, **characterized in that** the controller (12) has pilot control which, during actuation of the magnetic actuators (10), takes into account a distribution of the forces to the individual magnetic actuators (10) which is dependent on the position of the substrate carrier (5) relative to the sensing head (7).

9. Apparatus according to one of the preceding claims, **characterized in that** the magnetic actuators (10) form a magnetic circuit which is closed via the air gap between the substrate carrier (5) and ferromagnetic regions of the frame (1), thus producing a reluctance force which counteracts the spring force of the test contacts (8).

10. Apparatus according to Claim 9, **characterized in that** the magnetic actuators (10) are constructed from E-shaped iron cores, the limbs of which are directed to the ferromagnetic regions of the frame (1) and which are wound with at least one coil.

## Revendications

1. Dispositif de test de circuits intégrés au moyen d'une tête de balayage (7) comportant des contacts de test (8) qui sont comprimés sur les contacts électriques d'un substrat (6), comportant un cadre (1) sur lequel est fixée la tête de balayage (7), un support de substrat (5) destiné à recevoir le substrat (6) et comportant un élément magnétique destiné à générer une force au moyen de laquelle les contacts de test (8) sont comprimés sur les contacts électriques du circuit intégré, **caractérisé par** au moins trois actionneurs magnétiques (10) dont chacun est associé à un capteur de distance (11) et qui sont disposés autour du support de substrat (5) de manière à ce que les distances entre les actionneurs magnétiques (10) et le cadre (1) et, par conséquent, entre le support de substrat (5) et la tête de balayage (7), puissent être réglées.

2. Dispositif selon la revendication 1, **caractérisé en ce que** le support de substrat (5) est mobile par rapport à la tête de balayage (7) dans deux directions linéaires indépendantes (X, Y) qui s'étendent parallèlement à un plan du support de substrat (5).

3. Dispositif selon la revendication 2, **caractérisé en ce que** le support de substrat (5) peut être déplacé dans la première direction (X) par rapport au cadre (1) au moyen d'un premier axe linéaire (2) entraîné et **en ce qu'**un deuxième axe linéaire (3) est disposé perpendiculairement audit premier axe linéaire (2), au moyen duquel le support de substrat (5) est disposé de manière à pouvoir être déplacé dans la deuxième direction (Y).

4. Dispositif selon la revendication 2 ou 3, **caractérisé en ce que** le support de substrat (5) est disposé sur un plateau Z-Theta (4) au moyen duquel le substrat est déplacé dans une troisième direction (Z) qui est perpendiculaire aux première et deuxième directions (X, Y) ainsi qu'en rotation autour de la troisième direction (Z).

5. Dispositif selon l'une quelconque des revendications précédentes, **caractérisé en ce qu'**une force de pression (F_ref) définie ou une distance définie entre le support de substrat (5) et la tête de balayage (7) peut être prédéterminée dans un régulateur (12) destiné à attaquer les actionneurs magnétiques (10).

6. Dispositif selon la revendication 4 ou 5, **caractérisé en ce qu'**un courant maximal destiné à l'axe Z du plateau Z-Theta (4) peut être prédéterminé dans le régulateur (12).

7. Dispositif selon la revendication 5 ou 6, **caractérisé en ce qu'**un basculement du support de substrat (5) autour de la première ou de la deuxième direction (X, Y) peut être réglé au moyen du régulateur (12).

8. Dispositif selon la revendication 5, 6 ou 7, **caractérisé en ce que** le régulateur (12) comporte une commande préliminaire qui tient compte d'une répartition des forces entre les actionneurs magnétiques individuels (10) dépendant de la position du support de substrat (5) par rapport à la tête de balayage (7) lors de l'attaque des actionneurs magnétiques (10).

9. Dispositif selon l'une quelconque des revendications précédentes, **caractérisé en ce que** les actionneurs magnétiques (10) forment un circuit magnétique qui se referme à travers l'entrefer entre le support de substrat (5) et les zones ferromagnétiques du cadre (1) de manière à ce qu'il apparaisse une force de réluctance s'opposant à la force de rappel des contacts de test (8).

10. Dispositif selon la revendication 9, **caractérisé en ce que** les actionneurs magnétiques (10) sont constitués de noyaux de fer en forme de E dont les branches sont orientées vers les zones ferromagnétiques du cadre (1) et autour desquels est enroulée une bobine.
